# EUROPEAN PATENT SPECIFICATION

(11) **EP 3 917 008 B1**
(45) Date of publication and mention of the grant of the patent: **10.07.2024**
(21) Application number: 21173082.5
(22) Date of filing: 10.05.2021
(51) Int. Cl.: H03K 17/16, H03K 19/0185, H04L 25/03

(54) **LOW EMISSION ELECTRONIC SWITCH FOR SIGNALS WITH LONG TRANSITION TIMES**
EMISSIONSARMER ELEKTRONISCHER SCHALTER FÜR SIGNALE MIT LANGEN ÜBERGANGSZEITEN
COMMUTATEUR ÉLECTRONIQUE À FAIBLE ÉMISSION POUR DES SIGNAUX À LONG TEMPS DE TRANSITION

(30) Priority: 27.05.2020 US 202016884404
(43) Date of publication of application: 01.12.2021
(73) Proprietor: NXP B.V., 5656 AG Eindhoven (NL)
(72) Inventor: TORNILA OLIVER, Jaume, Redhill RH1 1QZ (GB)
(74) Representative: Hardingham, Christopher Mark

(56) References cited:
- US-A- 6 069 504
- US-A1- 2005 093 589
- US-A1- 2007 010 961

## Description

### BACKGROUND

### FIELD OF THE INVENTION

The present invention relates in general to electronic switching, and more particularly to a low emission electronic switch for switching binary signals having relatively long transition times.

### DESCRIPTION OF THE RELATED ART

Conventional switching techniques are known for making voltage transitions with low electro-magnetic emissions (EME) for meeting electromagnetic compatibility (EMC) standards. The conventional techniques may be sufficient for certain applications, but they present disadvantages for applications in which electromagnetic immunity (EMI) is important and longer transition times are required. The main disadvantages of those techniques are two-fold. A first disadvantage is that they use feedback control. A driver with feedback implies that the circuit is susceptible to disturbances during the transition time. Another disadvantage of feedback control is that the feedback circuit requires a control loop which adds complexity to the design and consumes valuable circuit area.

A second disadvantage of conventional techniques is that they use digitally-driven switches partitioned into many smaller switches in which each switch introduces a small and gradual change in resistance. The conventional technique may be applied to signals or communication buses working on the megahertz (MHz) range because the transitions are relatively fast and hence the number of switch partitions may be manageable. A typical case could be 32 partitions for switching frequency in the MHz range. However, with buses or signals having switching frequency in the kilohertz (kHz) range, the number of partitions required to ensure that each partition contributes very little to the emission is excessive, such as on the order of thousands. In that case, the conventional technique becomes prohibitive in terms of area and circuit complexity.

US 6 069 504 A discloses an output driver circuit offering control and logic level adjustment for high speed data communications in a synchronous memory such as a synchronous dynamic random access memory (SDRAM), in which a wave-shaping circuit comprises sequence circuits that provide sequentially time-delayed control terminal signals at output terminals that are electrically coupled to respective nodes.

US 2005/093589 A1 discloses circuitry for controlling the slope of rising and falling edges of a signal.

US 2007/010961 A1 discloses amplifiers that facilitate high-speed communication with calibrated drive strength and termination impedance.

### SUMMARY

According to the invention there is provided a switch apparatus and a method of switching a binary signal, as defined by the appended claims.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified schematic and block diagram of a switch circuit implemented according to one embodiment of the present disclosure.
FIG. 2 is a simplified schematic and block diagram of a switch circuit implemented according to another embodiment of the present disclosure.
FIG. 3 is a simplified schematic and block diagram of a switch circuit implemented according to yet another embodiment of the present disclosure.
FIG. 4 is a series of timing diagrams plotting an output signal DOUT, delay signals D1 - D6, and drive signals GD1 - GD6 versus time illustrating operation of an embodiment of the switch circuit of FIG. 1 in which N = 6.
FIGs 5, 6, and 7 are series of diagrams illustrating an exemplary voltage-current function for a local interconnect network (LIN) bus as an example with corresponding sizing of a set of electronic switches Q1 - Q31 for a configuration in which N = 31 according to one embodiment of the present disclosure.
FIG. 8 is a schematic diagram of slope circuitry implemented according to one embodiment of the present disclosure which may be used as the slope circuitry of any of the switch circuits of FIGs 1, 2, or 3.
FIG. 9 is a simplified schematic diagram of switch circuitry according to an alternative embodiment of the present disclosure including current branches implemented with resistors and transistors.

### DETAILED DESCRIPTION

There is a need for switching binary signals with low electromagnetic emissions (EME) for meeting electromagnetic compatibility (EMC) standards having long transition times without using feedback and without having to use an excessive number of switch partitions. A low emission electronic switch as described herein is able to switch signals having long transition times without using an excessive number of switches or switch partitions. The switch apparatus includes multiple current branches and slope circuitry, in which each current branch has a control input. Each of the current branches develops a corresponding current based on a drive signal applied to the control input, in which it combines with the current of any other activated current branches. The slope circuitry is responsive to an input signal and has multiple drive outputs each coupled to a control terminal of a corresponding one of the current branches. The slope circuitry sequentially activates or deactivates the current branches one at a time in response to transition of the input signal while applying a slope function to each current branch so that the output node follows the predetermined voltage-current function. Each current branch may be implemented using a MOS transistor or the like. Each current branch may include a resistor in series with a corresponding MOS transistor.

In one embodiment, N current branches are sequentially activated or deactivated by N slope control circuits of the slope circuitry. Sequential activation may be achieved using delay circuitry that provides one or more delay signals. In one embodiment, the delay circuitry provides N sequential delay signals responsive to the input signal, in which each delay signal is provided to an input of a corresponding one of the N slope control circuits. The first delay may be zero (i.e., the input signal is provided directly to a first slope control circuit for controlling a first current branch. In another embodiment, the input signal is provided, either directly or through the delay circuitry, to an input of a first control circuit, in which the N slope control circuits are daisy-chained together for sequential operation. In the daisy-chained configuration, the output of the first slope control circuit is coupled to the input of the second slope control circuit, having its output coupled to the input of a third slope control circuit, and so on up to the next-to-last last slope control circuit having its output coupled to the input of a last slope control circuit, which provides an Nth drive output to the Nth electronic switch.

The slope function of each of the slope control circuits provides a corresponding transition delay and is other than a step function. The shape of one or more of the slope functions of each of the slope control circuits may be linear or non-linear. Embodiments described herein illustrate a linear function in which a capacitor is charged or discharged with a relatively constant current level. A constant current may be achieved using a current-starved invertor or the like. Examples of non-linear slope functions include exponential slopes (of any suitable degree) or sinusoidal slopes or the like.

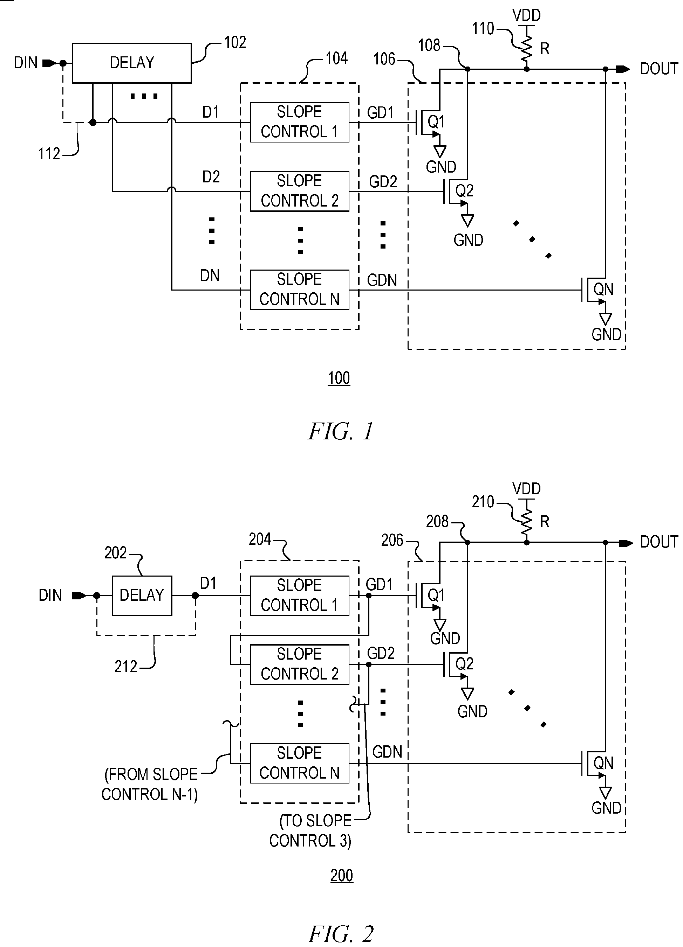

FIG. 1 is a simplified schematic and block diagram of a switch circuit 100 implemented according to one embodiment of the present disclosure. An input signal DIN is provided to an input of delay circuitry 102, providing a sequential set of N delayed signals D1, D2, ..., DN (D1 - DN), in which N is any suitable integer greater than 1. The delayed signals D1 - DN are provided to respective inputs of slope circuitry 104, having corresponding outputs providing a set of N drive signals GD1, GD2, ..., GDN (GD1 - GDN) to respective inputs of switch circuitry 106. The switch circuitry 106 is coupled between an output node 108 and a supply reference node, such as ground (GND), in which the output node 108 develops an output signal DOUT. A pull-up resistor 110 with resistance R is coupled between a supply voltage VDD and the output node 108.

In the illustrated embodiment, the slope circuitry 104 includes a series of N slope control circuits individually labeled slope control 1, slope control 2, ..., slope control N (or slope control circuits 1-N), each having an input receiving a corresponding one of the delay signals D1 - DN, respectively, and each providing a corresponding one of the drive signals GD1 - GDN. The switch circuitry 106 includes N electronic switches Q1, Q2, ..., QN (Q1 - QN) forming N switch branches, each having a control input receiving a corresponding one of the drive signals GD1 - GDN, and each having current terminals coupled between the output node 108 and GND. The electronic switches Q1 - QN are shown as N-type or N-channel devices, more specifically an N-channel MOS (NMOS) transistors, each having a gate terminal as a control input and drain and source terminals as the current terminals coupled between the output node 108 and GND. In other embodiments, the switch circuitry 106 may be configured as alternative polarity devices, such as P-type or P-channel MOS (PMOS) transistors, or as alternative device types, such as N-type or P-type bipolar junction transistors (BJTs) or the like (e.g., NPN or PNP transistors).

In operation, DIN and DOUT transition to opposite binary states with respect to each other. In an initial condition, D1 - DN and GD1 - GDN each have the same binary state as DIN, in which each of these signals ultimately switch between first and second binary states. In response to DIN transitioning from the first binary state to the second binary state, D1 transitions from the first binary state to the second binary state after a first delay, then D2 transitions from the first binary state to the second binary state after a second delay, and so on up to that last delay signal DN, which transitions after N delays. Each of the N delays may have substantially the same period or may have different periods. Each of the drive signals GD 1 - GDN begin transitioning in response to a transition of the corresponding one of the delay signals D1 - DN. The transition of each of the drive signals GD1 - GDN, however, follows a corresponding slope function defined by the corresponding one of the slope control circuits 1-N. Thus, in response to the D1 transition, GD1 transitions following a slope function defined by the slope control circuit 1, in response to the D2 transition, GD2 transitions following a slope function defined by the slope control circuit 2, and so on up to transition of DN, in which GDN transitions following a slope function defined by the slope control circuit N.

The delay circuitry 102 may be implemented in any suitable manner. In one embodiment, for example, the delay circuitry 102 may be implemented as a delay pipeline of delay buffers (not shown) including any combination of non-inverting or inverting delay buffers or the like. In another embodiment, the delay circuitry 102 may be implemented as a pipeline of daisy-chained flip-flops (not shown) driven by a digital clock (not shown) having a suitable frequency for controlling the delay periods. In one embodiment, each of the delays 1 - N are substantially the same. In another embodiment, one or more of the delays may be different up to all delays being different from each other. For example, the delay periods may increase or decrease from one to the next.

In an alternative embodiment, the first delay period from DIN to D1 may be bypassed as indicated by connection line 112. In this case, DIN may be provided directly to the input of the first slope control circuit 1. Alternatively, the delay from DIN to D1 may be minimal or zero. The remaining delay signals D2 - DN are sequentially delayed in the same manner as previously described yet relative to DIN. Operation is substantially similar although the level of emissions may be changed.

In one embodiment, each of the slope control circuits 1 - N may be configured in substantially the same manner with the same slope function for each. In another embodiment, one or more of the slope control circuits 1 - N may be configured differently for different slope functions. The shape of one or more slope functions may be linear or non-linear. Examples of non-linear slope functions include exponential slopes (of any suitable degree) or sinusoidal slopes or the like. It is noted that each slope function is other than a simple step function so that none of the switches Q1 - QN are digitally-controlled. Each slope function transitions between first and second voltage levels (e.g., between VDD and GND) with a configured or an inherent delay to minimize switching emissions from one switch to the next.

Each of the switches Q1 - QN turn on or off in response to transitioning of a corresponding one of the gate drive signals GD1 - GDN. If each of the switches Q1 - QN are initially off and GD1 - GD2 transition from low (e.g., at or near ground) to high (up to VDD), then each of the switches Q1 - QN are turned on so that DOUT transitions from high to low. If each of the switches Q1 - QN are initially on and GD1 - GD2 transition from high to low, then each of the switches Q1 - QN are turned off so that DOUT starts low and is pulled high via the pull-up resistor R.

As further described herein, each of the switches Q1 - QN may be sized to achieve a corresponding current during the switching process. Although each switch may have a particular on-resistance when in its corresponding triode region, one or more of the switches Q1 - QN may also be in, or may pass through, its corresponding saturation region of operation during the switching process. This means that each switch develops a corresponding current when acting as a current source or as a resistor during each switching transition. Roughly speaking, during switching, when the drain voltage is larger than the gate voltage, then the transistor is in its saturation region, and when the drain voltage is at or near the gate voltage, then the transistor is in its triode region. The amount of time that the switches Q1 - QN are in triode or saturation depends on the particular implementation, the voltages driving the switches, and the voltage level of VDD.

FIG. 2 is a simplified schematic and block diagram of a switch circuit 200 implemented according to another embodiment of the present disclosure. The switch circuit 200 includes delay circuitry 202, slope circuitry 204, switch circuitry 206, and a pull-up resistor 210 with resistance R. The switch circuitry 206 is configured in a substantially similar manner as the switch circuitry 106 including N electronic switches Q1 - QN forming N current branches, each having a control input receiving a corresponding one of N drive signals GD1 - GDN, and each having current terminals coupled between an output node 208 and GND. The resistor 210 is coupled between VDD and the output node 208, in which the output node 208 develops the output signal DOUT in similar manner as the switch circuit 100.

The input signal DIN is provided to the delay circuitry 202, which outputs a single delay signal D1 to an input of a first slope control circuit 1 of the slope circuitry 204. The slope circuitry 204 provides the drive signals GD1 - GDN to the control inputs of the switches Q1 - QN, respectively, in similar fashion as the switch circuit 100. In this case, however, rather than receiving separate delay signals from a delay circuit, the slope circuitry 204 includes N slope control circuits 1 - N coupled in a daisy-chained configuration. In particular, the first drive signal GD1 output from the first slope control circuit 1 is provided to an input of the second slope control circuit 2, having an output providing the drive signal GD2 to an input of the third second slope control circuit 3 (not shown), and so on up to the last slope control circuit N, having an input receiving a gate drive output from a next-to-last slope control circuit N-1, and having an output providing GDN to the control input of the last switch QN.

Operation of the switch circuit 200 is substantially similar to the switch circuit 100, except that rather than propagating delay via the delay circuitry 202, delay is iteratively propagated via the delayed gate drive signals GDx in which x is an index from 1 to N-1. Thus, after DIN transitions, D1 transitions after the delay through the delay circuitry 202. GD1 begins transitioning according to the slope function of the slope control circuit 1 after D1 transitions. GD2 - GDN each begin transitioning according to the slope functions of the slope control circuit 2-N, respectively, one at a time in iterative fashion.

In an alternative embodiment, the delay circuitry 202 may be eliminated (or otherwise bypassed) as indicated by connection line 212. In this case, DIN is provided directly to the input of the first slope control circuit 1. Operation is substantially similar although the level of emissions may be modified somewhat.

Each of the slope control circuits 1 - N of the switch circuit 200 may be configured in substantially similar manner as described for the switch circuit 200, in which each slope function may be the same or different and may be linear or non-linear depending upon the configuration. Again, each slope function transitions between first and second voltage levels with a configured or an inherent delay to minimize switching emissions from one switch to the next. As previously described, each of the switches Q1 - QN is sized to achieve a corresponding amount of current during the switching process. The amount of time that the switches Q1 - QN are in triode or saturation depends on the particular implementation, the voltages driving the switches, and the voltage level of VDD.

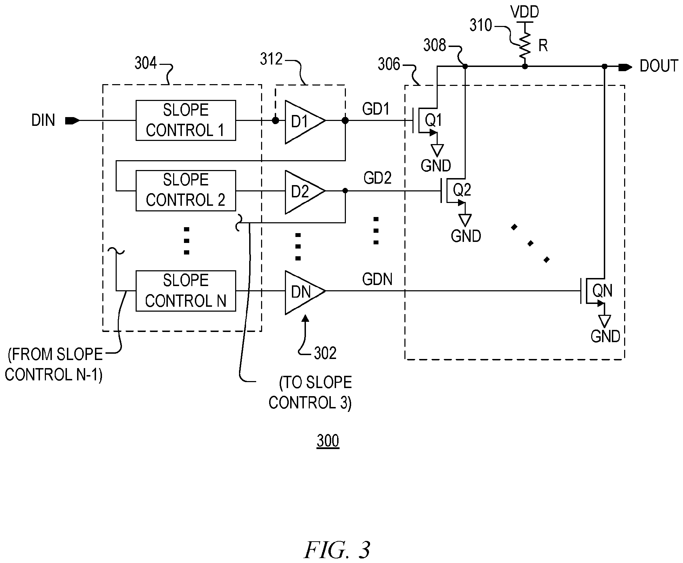

FIG. 3 is a simplified schematic and block diagram of a switch circuit 300 implemented according to another embodiment of the present disclosure. The switch circuit 300 includes delay circuitry 302, slope circuitry 304, switch circuitry 306, and a pull-up resistor 310 with resistance R. The switch circuitry 306 is configured in a substantially similar manner as the switch circuitry 106 including N electronic switches Q1 - QN forming N current branches, each having a control input receiving a corresponding one of N drive signals GD1 - GDN, and each having current terminals coupled between an output node 308 and GND. The resistor 310 is coupled between VDD and the output node 308, in which the output node 308 develops the output signal DOUT in similar manner as the switch circuits 100 and 200.

The slope circuitry 304 of the switch circuit 300 is daisy-chained in similar manner as the slope circuitry 204 of the switch circuit 200, except that the delay circuitry 302 is interposed between the slope circuitry 304 and the switch circuitry 306. The slope circuitry 304 includes N slope control circuits 1 - N and the delay circuitry 302 includes N delay circuits D1, D2, ..., DN (D 1 - DN). The input signal DIN is provided to the input of the first slope control circuit 1, having its output coupled to the input of a first delay circuit D1, having an output providing the first drive signal GD1. GD1 is provided to the input of the second slope control circuit 2, having its output coupled to the input of a second delay circuit D2, having an output providing the first drive signal GD2. GD2 is provided to the input of the next slope control circuit having its output provided to the input of the next delay circuit proving the next drive signal and so on up to the last slope control circuit N, which receives the drive signal GDN-1 and has an output provided to the input of the last delay circuit DN providing the last drive signal GDN.

Each delay circuit D1 - DN of the delay circuitry 302 is illustrated as a buffer or the like which may be implemented as any number of delay buffers providing a corresponding amount of delay. Operation of the switch circuit 300 is substantially similar to the switch circuit 200 in which the output of each of the slope control circuits 1 - N is delayed and the delay circuitry outputs providing the delayed gate drive signals GDx are iteratively coupled to the next slope and delay circuit from first to last. In an alternative embodiment, the first delay circuit D1 may be eliminated (or otherwise bypassed) as indicated by connection line 312. In this case, the output of the first slope control circuit 1 is provided as GD1. Operation is substantially similar.

Each of the slope control circuits 1 - N of the switch circuit 300 may be configured in substantially similar manner as described for the switch circuits 100 or 200, in which each slope function may be the same or different and may be linear or non-linear depending upon the configuration. Again, each slope function transitions between first and second voltage levels with a configured or an inherent delay to minimize switching emissions from one switch to the next. As previously described, each of the switches Q1 - QN is sized to achieve a corresponding amount of current during the switching process. The amount of time that the switches Q1 - QN are in triode or saturation depends on the particular implementation, the voltages driving the switches, and the voltage level of VDD.

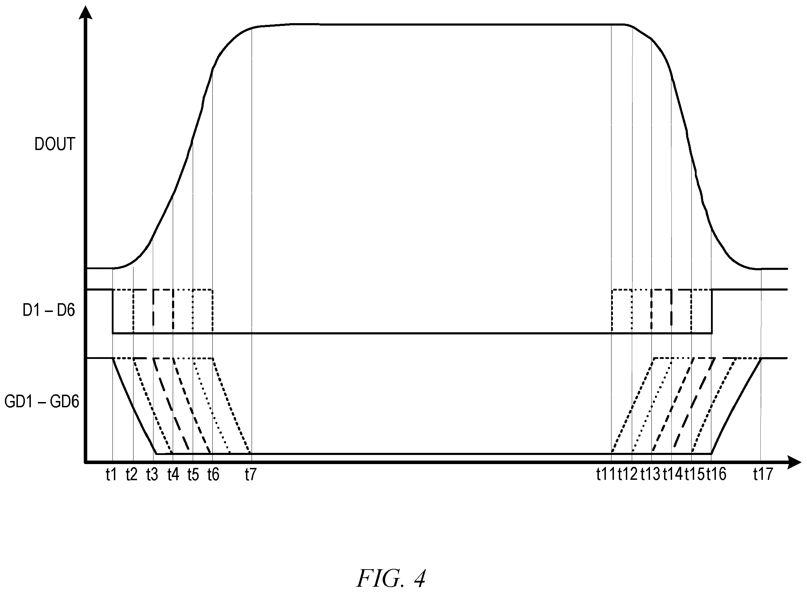

FIG. 4 is a series of timing diagrams plotting the output signal DOUT, the delay signals D1 - D6, and the drive signals GD1 - GD6 versus time illustrating operation of an embodiment of the switch circuit 100 in which N = 6. DOUT is initially at a low voltage level, such as near GND or less than one (1) Volt (V). Although not shown, prior to a first time 11, the input signal D1 transitions from a high value (e.g., from VDD or logic 1) to a low value (e.g., to GND or logic 0). After a first delay, D1 transitions from high to low at time t1 shown with negligible switching delay. In response, GD1 begins sloping down from high to low with a substantially linear slope to turn off Q1. As Q1 is turning off, DOUT begins to rise. After a second delay, D2 transitions from high to low at time t2 with negligible switching delay, and GD2 begins sloping down from high to low with a substantially linear slope to turn off Q2. At time t2, GD1 is still falling and has only reached about half its value when GD2 begins decreasing. As Q2 is turning off, DOUT continues to rise at an increased rate. Operation repeats in this manner for subsequent delays 3 - 6 for times t3 to t6, in which signals D3 - D6 sequentially transition from high to low, GD3 - GD6 begin sequentially sloping down from high to low, and switches Q3 - Q6 are sequentially turning off in response to sloping inputs. As the switches Q1 - Q6 are sequentially turned off in this manner, DOUT rises towards its high voltage level. At subsequent time t7, the signals GD1 - GD6 have all reached their low levels so that DOUT is pulled high via pull-up resistor 110.

In the illustrated embodiment of FIG. 4, each of the delay periods from D1 to D6 are substantially equal to each other, and each of the slope functions of the slope control circuits 1-6 are substantially linear and substantially equal to each other. As described further herein, the respective sizes of the switches Q1 - Q6 with corresponding on-resistances and saturation current capabilities are selected so that DOUT follows a predetermined voltage-current function as shown. Adjustment of the delays, the slope functions and the sizes of the switches Q1 - Q6 enables corresponding adjustment and configuration of the voltage-current function.

Operation is similar for sequentially turning off the switches Q1 - Q6. Just before a sequential time t11, the input signal D1 transitions from a low to high. After the first delay, D1 transitions from low to high at time t11 with negligible switching delay, and GD1 begins increasing from low to high with a substantially linear slope turning Q1 back on. As Q1 turns on, DOUT begins to fall. After the second delay, D2 transitions from low to high at time 112 with negligible switching delay, and GD2 begins sloping up from low to high with a substantially linear slope turning on Q2. At time t12, GD1 is still rising and has only reached about half its value when GD2 begins increasing. As Q2 turns on, DOUT continues to fall at an increased rate. Operation repeats in this manner for subsequent delays 3 - 6 for times t13 to t16, in which signals D3 - D6 sequentially transition from high to low, GD3 - GD6 begin sequentially sloping up from low to high, and switches Q3 - Q6 are sequentially turned on. As the switches Q1 - Q6 are sequentially turned on in this manner, DOUT decreases towards its low voltage level. At subsequent time t17, the signals GD1 - GD6 have all reached their high levels and DOUT is pulled low.

It is noted that if the slope circuitry 104 were eliminated or otherwise replaced by digital drivers such that the switches Q1 - Q6 were digitally driven, DOUT would transition in stair-step fashion generating a significant amount of emissions. Instead, the slope functions of the slope circuitry 104 smooths out the transitions substantially reducing the amount of emissions. Although only 6 switches are shown, the number of switches may be adjusted to ensure that the corresponding amount of emissions meet the applicable EMC standards under all circuitry and ambient operating conditions (e.g., given applicable variations and ranges of voltages, circuitry, currents, temperature, etc.).

Operation of the switch circuits 200 and 300 are substantially similar to that of the switch circuit 100 for the same number of switches. In any given configuration, the corresponding emissions may be calculated or empirically determined, in which N, the slope functions and the switch sizes may be adjusted to reduce emissions to an allowable or acceptable level.

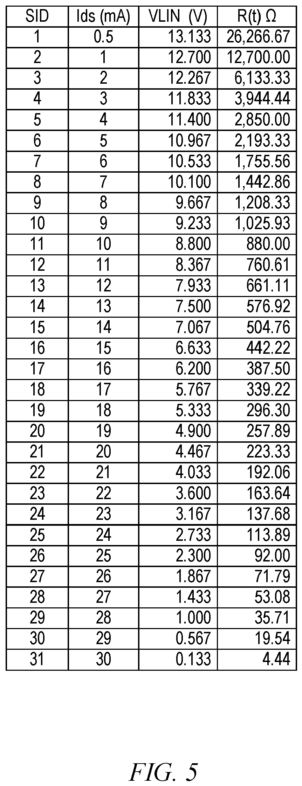

FIGs 5, 6, and 7 are a series of diagrams illustrating an exemplary voltage-current function for a local interconnect network (LIN) bus as an example with corresponding sizing of a set of electronic switches Q1 - Q31 for a configuration in which N = 31 according to one embodiment of the present disclosure. FIG. 5 illustrates a chart 502 listing a switch identifier (SID) from 1 to 31 (representing switches Q1 - Q31), the desired total drain-to-source current Ids from 0.5 milliamperes (mA) to 30mA, the desired bus voltage VLIN from about 13.133V down to 0.133V, and the corresponding total resistance R(t) of a total number of activated switches from 26,266.67 Ohms (Ω) down to 4.444Ω to achieve the current level Ids and corresponding voltage level VLIN. The desired total resistance R(t) = VLIN/Ids as each switch is activated or deactivated.

Given the load resistance (e.g., pull-up resistance R of resistor 110), the desired voltage VLIN and the desired current Ids, an on-resistance value for each switch may be determined according to Ohm's law. Given the total resistance value at each time, the on-resistance value for each individual switch can be determined using simple algebra. The on-resistance R(Q1) of the first switch Q1 is the same as the total resistance value, or R(Q1) = R(t) = 26,267 Ω. The on-resistance R(Q2) of the second switch Q2 is calculated based on R(Q1) = 26,267Ω and R(t) = 12,700Ω for a parallel combination in which R(t) = R(Q1)∥R(Q2) = R(Q1∥Q2) = R(Q1)*R(Q2)/[R(Q1)+R(Q2)] = 12,700Ω. Solving for R(Q2), R(Q2) = R(t)/[1-R(t)/R(Q1)] = 26,267/[1 - 12,700/26,267] = 24,589Ω. The on-resistance of the third switch R(Q3) is calculated based on R(Q1∥Q2) and R(t) = 6,133Ω, so that R(Q3) = R(t)/[1-R(t)/ R(Q1∥Q2)] = 6,133/[1 - 6,133/12,700] = 11,861Ω. The on-resistances of the remaining switches Q4 to Q31 may be determined in the same manner to achieve the corresponding value of R(t) according to the chart 402.

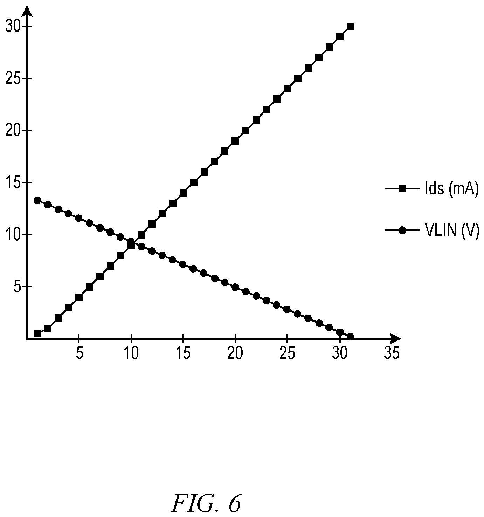

FIG. 6 is a corresponding switch sizing graph plotting both Ids and VLIN for each switch according to the switch ID or SID. VLIN linearly ranges from 13.133V when all of the switches Q1 - Q31 are turned off to 0.133V when all of the switches Q1 - Q3 are turned on. Ids linearly ranges from 0.5mA when all of the switches Q1 - Q31 are turned off to 30mA when all of the switches Q1 - Q3 are turned on.

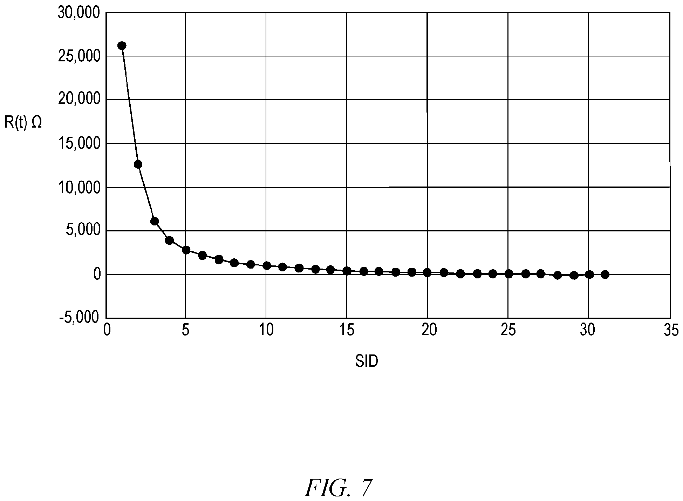

FIG. 7, is a corresponding total resistance graph plotting the corresponding total resistance R(t) in Ohms versus switch ID or SID, meaning the total number of switches that are activated as each switch is sequentially activated or deactivated. R(t) ranges from 26,267Ω when all of the switches Q1 - Q31 are turned off to 4.44Ω when all of the switches Q1 - Q31 are turned on.

It is noted that the size of each of the switches Q1 - Q31 may be selected and adjusted to achieve a target on-resistance. Also, if a switch needs to have an on-resistance that is higher than the minimum size switch for a given configuration, a resistor in series with the current terminals of the switching resistor can be added to implement the desired on-resistance. It is also noted that in this configuration, the on-resistances may be selected and used to provide an initial configuration. As previously described, however, each of the switches Q1 - QN in a given configuration may be sized to target a corresponding current level during the switching process, and that each switch may transition between its off, triode, and saturation regions during the switching process. The switch sizes may be adjusted accordingly.

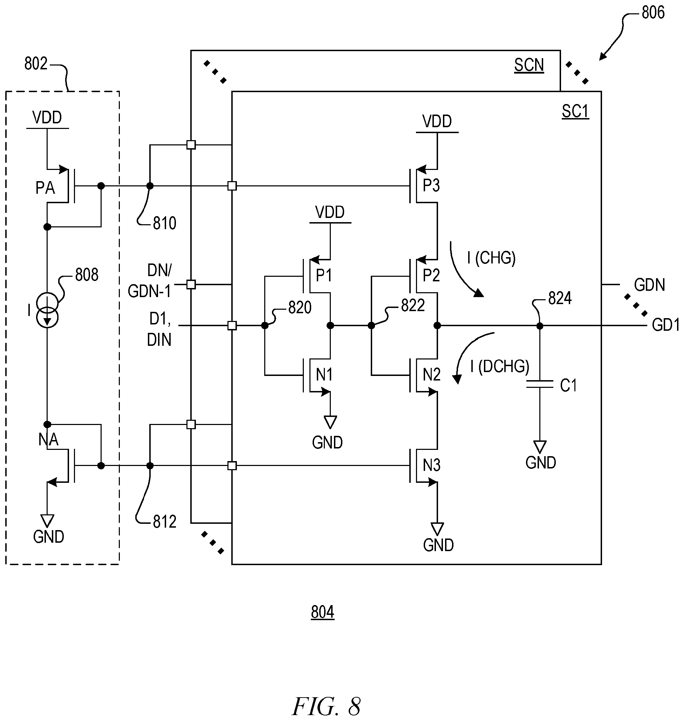

FIG. 8 is a schematic diagram of slope circuitry 804 implemented according to one embodiment of the present disclosure. The slope circuitry 804 may be used as either the slope circuitry 104 of the switch circuit 100, or as the slope circuitry 204 of the switch circuit 200, or as the slope circuitry 304 of the switch circuit 300. The slope circuitry 804 includes current mirror circuitry 802 and a set of N slope control circuits 806, individually labeled SC1, ... SCN (SC1 - SCN). Although only the first slope control circuit SC1 and the last slope control circuit SCN are shown, it is understood that N may be any suitable integer number so that any number of slope control circuits may be included (e.g., 4, 6, 8, 10, 16, 20, 32, 40, 50, 64, etc.). In addition, the details of only the first slope control circuit SC1 are shown, where it is understood that the remaining slope control circuits SC2, ..., SCN may be configured in substantially the same manner. The current mirror circuitry 802 is common to each of the slope control circuits SC1 - SCN to reduce area and to allow for easy trimming if desired or required.

The current mirror circuitry 802 includes a PMOS transistor PA, a current source 808, and an NMOS transistor NA coupled between VDD and GND and developing a current I. The source of PA is coupled to VDD, and its gate and drain terminals are coupled to an upper node 810 further coupled to an input of the current source 808. An output of the current source 808 is coupled to a lower node 812, which is further coupled to the drain and gate terminals of NA having its source terminal coupled to GND. Although the current mirror circuitry 802 is shown as a single current source driving each of the slope control circuits SC1 - SCN, in an alternative embodiment separate current mirrors with corresponding current sources may be provided for each slope control circuit.

The slope control circuit SC1 has an input node 820 receiving the delay signal D1 (which is the first delay signal of the switch circuit 100 or the only delay signal for the switch circuit 200), or receiving the input signal DIN (for the switch circuit 300). Node 820 is internally coupled to the gate terminal of a PMOS transistor P1 and to the gate terminal of an NMOS transistor N1. P1 has its source terminal coupled to VDD and its drain terminal coupled to an intermediate node 822. N1 has its source terminal coupled to GND and its drain terminal coupled to node 822. Node 822 is further coupled to the gate terminal of another PMOS transistor P2 and to the gate terminal of another NMOS transistor N2. The drain terminals of P2 and N2 are coupled together at an output node 824 developing the first drive signal GD1. Another PMOS transistor P3 has a source terminal coupled to VDD, a gate terminal coupled to the upper node 810, and a drain terminal coupled to the source terminal of P2. Another NMOS transistor N3 has a source terminal coupled to GND, a gate terminal coupled to the lower node 812, and a drain terminal coupled to the source terminal of N2. A capacitor C1 is coupled between the output node 824 and GND. As noted above, each of the remaining slope control circuits SC2 - SCN) may be configured in substantially the same manner. The last slope control circuit SCN has an input receiving either delay signal DN (for the switch circuit 100) or a drive signal GDN-1 (for the switch circuit 200), and has an output providing the drive signal GDN.

P1 and N1 form a first inverter for switching the intermediate node 822 between VDD and GND depending upon the state of the input signal D1. P2, P3, N2 and N3 form a "current-starved" inverter that drives current I to either charge (CHG) or discharge (DCHG) the capacitor C1 depending upon the state of the intermediate node 820. P3 is coupled in a current mirror configuration with PA and N3 is coupled in a current mirror configuration with NA so that the drain-source current through each of P3, P2, N2, and N3 is I as controlled by the current source 808 of the current mirror circuitry 802. When D1 is asserted high, intermediate node 822 is asserted low turning P2 on and N2 off, so that a charge (CHG) current I flows through P3 and P2 to charge the capacitor C1. When D1 is asserted low, intermediate node 822 is asserted high turning N2 on and P2 off, so that a discharge (DCHG) current I flows through N3 and N2 to discharge the capacitor C1. In this manner, the capacitor C1 is effectively charged or discharged with a constant current I to create a linear slope voltage function at the drive signal GD1 such as shown in FIG. 3. As noted above, the current mirror circuitry 802 is common to all of the slope control circuits SC1 - SCN so that the slope function is substantially the same for each.

In one embodiment, I is a constant current value. It is noted, however, that the current source 808 does not need to be a constant function. Other functions are contemplated, such as a sinusoidal function (e.g., half-sine wave) or an exponential function or the like. The illustrated embodiment uses constant current through a gate capacitor as the slope function. Alternative slope functions may be implemented. In another embodiment, low pass filters using resistors and capacitors may be used. In yet another embodiment, split-switches may be used. In any event, at least one up to all of the slope functions are other than a non-delayed step function.

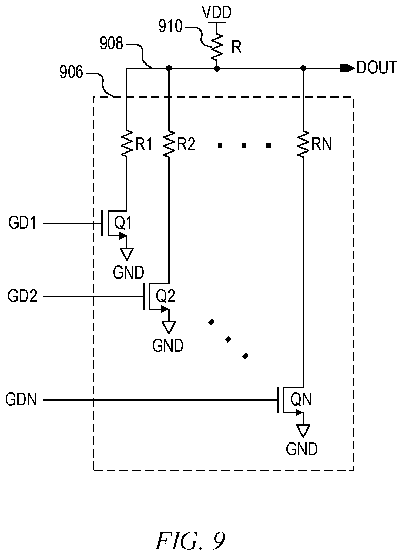

FIG. 9 is a simplified schematic diagram of switch circuitry 906 according to an alternative embodiment of the present disclosure. The N drive signals GD1 - GDN are provided to the gate terminals of N electronic switches Q1 - QN in a similar manner as previously described, each having a source terminal coupled to GND. The drain terminal of each of the switches Q1 - QN, however, is coupled to one end of a corresponding one of N resistors R1, R2, ..., RN (R1 - RN), having their other ends coupled to an output node 908 developing the output signal DOUT. In this manner, each of the N current branches includes an electronic switch coupled in series with a corresponding one of N resistors. A pull-up resistor 910 with resistance R is coupled between VDD and the output node 908. The switch circuitry 906 may replace the switch circuitry 106, 206, or 306 of the switch circuits 100, 200, or 300, respectively. Although operation is similar, the size of each of the switches Q1 - QN and the resistances of the corresponding resistors R1 - RN are selected or chosen to achieve a corresponding current to ultimately achieve the target or predetermined voltage-current function of DOUT as previously described.

It is noted that each of the switches Q1 - QN of the switch circuitry, when used alone (as shown for the switch circuitry 106, 206, or 306) or in combination with a corresponding one of the N resistors R1 - RN (as shown for the switch circuitry 908), forms a corresponding one of N current branches coupled between an output node (e.g., 108, 208, 308, 708) and a reference node (e.g., GND). Each current branch develops a corresponding current as it is being activated or deactivated by the corresponding slope function such that, when combined with other current branches during the switching process, causes the output node providing the DOUT voltage to follow the target voltage-current function with minimal or reduced EME.

Although there is no theoretical limit to the number N, such that N may be in the hundreds or even thousands, an excessive number of switching branches becomes prohibitive in terms of area and circuit complexity. In a conventional configuration using digitally-driven switches, each switch can advance the signal only so much without generating significant emissions. In this manner, an excessive number of switches (e.g., thousands) would be required using digitally-driven switches for a signal having a relatively low switching frequency and a corresponding long transition time to meet the applicable EMC standards. Instead, a low emission electronic switch implemented according to embodiments described herein reduces EME per switch so that N may be substantially reduced as compared to the conventional configuration while still meeting the applicable EMC standards. Thus, N can be limited to a more practicable number, such as a hundred or less (e.g., 32 in some embodiments) rather than thousands. In any given configuration, mathematical or empirical methods or the like may be used to determine a minimum number of switches, the switch sizes, series resistor values (if used), and the corresponding delays that perform switching while ensuring that the EMC standards are met.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive logic or negative logic may be used in various embodiments in which the present invention is not limited to specific logic polarities, device types or voltage levels or the like. For example, logic states, such as logic low and logic high may be reversed depending upon whether the pin or signal is implemented in positive or negative logic or the like. In some cases, the logic state may be programmable in which the logic state may be reversed for a given logic function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A switch apparatus (100, 200, 300), comprising:
a plurality of current branches, each having current terminals coupled between an output node (108, 208, 308) and a reference node (GND), each having a control terminal, and each developing a current in response to a drive signal (GD1-N) applied to the control terminal; and
slope circuitry (104, 204. 304) having at least one input responsive to an input signal (DIN) and having a plurality of drive outputs each coupled to a control terminal of a corresponding one of the plurality of current branches, wherein the slope circuitry (104, 204, 304) activates or deactivates the plurality of current branches one at a time according to a corresponding one of a plurality of slope functions in response to transition of the input signal (DIN) so that the output node (108, 208, 308) follows a predetermined voltage-current function,
wherein each slope function is a linear or non-linear function other than a step function to transition each drive output between first and second voltage levels with a configured or inherent delay, **characterized in that** the slope circuitry (804) further comprises:
a current mirror (802) that drives a predetermined current between an upper node (810) and a lower node (812); and
a plurality of slope control circuits (SC1-SCN), each slope circuit comprising:
a capacitor (C1) coupled to a drive output node (824) providing a corresponding one of the plurality of drive signals (GD1-GDN);
a first inverter having an input coupled to an input node (820) and having an output coupled to an intermediate node (822); and
a second inverter coupled to the upper and lower nodes (810, 812) of the current mirror (802), having an input coupled to the intermediate node (822) and an output coupled to the drive output node (824) for charging or discharging the capacitor (C1) with the predetermined current.

2. The switch apparatus (100, 200, 300) of claim 1, wherein:
the predetermined voltage-current function comprises a plurality of voltage-current points including a plurality of voltage values incrementally ranging between the first voltage level and the second voltage level and a corresponding plurality of current values; and
wherein a resistance of each of the plurality of current branches is selected to combine with a total resistance to achieve a corresponding one of the plurality of voltage-current points.

3. The switch apparatus (100) of any preceding claim, further comprising:
delay circuitry (102) having an input receiving the input signal (DIN) and having a plurality of outputs providing a plurality of delayed signals (D1-N) each separated by an incremental delay time; and
wherein the plurality of slope control circuits (SC1-SCN) each have an input receiving one of the plurality of delayed signals (D1-N) and each have an output providing a corresponding one of the plurality of drive outputs according to a corresponding one of the plurality of slope functions.

4. The switch apparatus (200) of any one of claim 1 or claim 2, wherein the plurality of slope control circuits (SC1-N) are coupled in a daisy-chain from a first slope control circuit to a last slope control circuit, wherein the first slope control circuit receives the input signal (DIN), and wherein each of the first slope control circuit to a next-to-last slope control circuit has a drive output coupled to an input of a next slope control circuit (SC1-N).

5. The switch apparatus (300) of claim 4, further comprising delay circuitry (302) comprising a plurality of delay circuits (D1-DN) each delaying a corresponding one of the plurality of drive outputs at the outputs of the slope circuitry (204).

6. The switch apparatus (200) of any one of claim 1 or claim 2, further comprising:
delay circuitry (202) having an input receiving the input signal and an output providing a delayed signal; and
wherein the slope circuitry (204) comprises a plurality slope control circuits (SC1-SCN) coupled in a daisy-chain from a first slope control circuit to a last slope control circuit, wherein the first slope control circuit receives the delayed signal, and wherein each of the first slope control circuit to a next-to-last slope control circuit has a drive output coupled to an input of a next slope control circuit.

7. The switch apparatus (100, 200, 300) of any preceding claim , wherein each of the plurality of slope control circuits (SC1-SCN) comprises:
a first P-channel device (P1) having a source terminal coupled to a supply node (VDD), having a gate terminal coupled to an input node (820), and having a drain terminal coupled to an intermediate node (822);
a first N-channel device (N1) having a source terminal coupled to a reference supply node (GND), having a gate terminal coupled the input node (820), and having a drain terminal coupled to the intermediate node (822);
a second P-channel device (P3) having a source terminal coupled to the supply node (VDD), having a gate terminal coupled to the upper node (810), and having a drain terminal;
a third P-channel device (P2) having a source terminal coupled to the drain terminal of the second P-channel device (P3), having a gate terminal coupled to the intermediate node (822), and having a drain terminal coupled to the drive output node (824);
a second N-channel device (N2) having a drain terminal coupled to the drive output node (824), having a gate terminal coupled to the intermediate node (822), and having a source terminal; and
a third N-channel device (N3) having a drain terminal coupled to the source terminal of the second N-channel device (N2), having a gate terminal coupled to the lower node (812), and having a source terminal coupled to the reference supply node (GND).

8. The switch apparatus (100, 200, 300) of any preceding claim, wherein each of the plurality of current branches comprises a transistor having a first current terminal coupled to the output node, having a second current terminal coupled to the reference node, and having a control terminal receiving a corresponding one of the plurality of drive outputs, and wherein the transistor is sized to provide a corresponding current.

9. The switch apparatus (100, 200, 300) of any one of claim 1 to claim 7, wherein each of the plurality of current branches comprises:
a resistor having a first end coupled to the output node and having a second end; and
a transistor having a first current terminal coupled to the second end of the resistor, a second current terminal coupled to the reference node, and a control terminal receiving a corresponding one of the plurality of drive outputs;
wherein a resistance of the resistor and a size of the transistor are selected to provide a corresponding amount of current.

10. A method of switching a binary signal using a switch apparatus (100, 200, 300) of claim 1, comprising:
transitioning an input signal; and
applying a corresponding one of a plurality of slope functions, one at a time, to drive a corresponding one of a plurality of drive outputs to control a corresponding one of a plurality of current branches provided between an output node (108, 208, 308) and a reference node so that the output node (108, 208, 308) follows a predetermined voltage-current function,
wherein each slope function is a linear or non-linear function other than a step function to transition each drive output between first and second voltage levels with a configured or inherent delay.

11. The method of claim 10, wherein the applying comprises applying a corresponding one of the plurality of slope functions to activate or deactivate a corresponding one of the plurality of current branches.

12. The method of claim 10 or claim 11, wherein the applying comprises selectively switching the current-starved inverter driving a charge or discharge current to the capacitor (C1).

13. The method of any of claims 10 to 12, further comprising:
delaying the input signal to provide a plurality of delayed signals (D1-N) each separated by an incremental delay time; and
receiving each of the plurality of delayed signals (D1-DN) by a corresponding one of the plurality slope control circuits (SC1-SCN), wherein each provides a corresponding one of the plurality of drive outputs according to a corresponding one of the plurality of slope functions.

## Patentansprüche

1. Schaltvorrichtung (100, 200, 300), die Folgendes umfasst:
eine Vielzahl von Stromzweigen, die jeweils Stromanschlüsse aufweisen, die zwischen einem Ausgangsknoten (108, 208, 308) und einem Referenzknoten (GND) gekoppelt sind, wobei jeder einen Steueranschluss aufweist und jeder einen Strom in Reaktion auf ein an den Steueranschluss angelegtes Treibersignal (GD1-N) entwickelt; und
Slope-Schaltung (104, 204, 304) mit mindestens einem Eingang, der auf ein Eingangssignal (DIN) anspricht, und mit einer Vielzahl von Treiberausgängen, die jeweils mit einem Steueranschluss eines entsprechenden der Vielzahl von Stromzweigen gekoppelt sind, wobei die Slope-Schaltung (104, 204, 304) die Vielzahl von Stromzweigen jeweils einzeln gemäß einer entsprechenden einer Vielzahl von Slope-Funktionen in Reaktion auf einen Übergang des Eingangssignals (DIN) aktiviert oder deaktiviert, so dass der Ausgangsknoten (108, 208, 308) einer vorbestimmten Spannungs-Strom-Funktion folgt,
wobei jede Slope-Funktion eine lineare oder nicht-lineare Funktion ist, die keine Stufenfunktion ist, um jeden Treiberausgang zwischen ersten und zweiten Spannungspegeln mit einer konfigurierten oder inhärenten Verzögerung zu überführen, **dadurch gekennzeichnet, dass** die Slope-Schaltung (804) ferner Folgendes umfasst:
einen Stromspiegel (802), der einen vorbestimmten Strom zwischen einem oberen Knoten (810) und einem unteren Knoten (812) treibt; und
eine Vielzahl von Slope-Steuerschaltungen (SC1-SCN), wobei jede Slope-Schaltung folgendes umfasst:
einen Kondensator (C1), der mit einem Treiberausgangsknoten (824) gekoppelt ist, der ein entsprechendes der Vielzahl von Treibersignalen (GD1-GDN) bereitstellt;
einen ersten Inverter, dessen Eingang mit einem Eingangsknoten (820) gekoppelt ist, und dessen Ausgang mit einem Zwischenknoten (822) gekoppelt ist; und
einen zweiten Inverter, der mit dem oberen und dem unteren Knoten (810, 812) des Stromspiegels (802) gekoppelt ist, mit einem Eingang, der mit dem Zwischenknoten (822) gekoppelt ist, und einem Ausgang, der mit dem Treiberausgangsknoten (824) gekoppelt ist, zum Laden oder Entladen des Kondensators (C1) mit dem vorbestimmten Strom.

2. Schaltvorrichtung (100, 200, 300) nach Anspruch 1, wobei:
die vorbestimmte Spannungs-Strom-Funktion eine Vielzahl von Spannungs-Strom-Punkten umfasst, die eine Vielzahl von Spannungswerten, die inkrementell zwischen dem ersten Spannungspegel und dem zweiten Spannungspegel liegen, und eine entsprechende Vielzahl von Stromwerten einschließen; und
wobei ein Widerstand jedes der Vielzahl von Stromzweigen so ausgewählt wird, dass er mit einem Gesamtwiderstand kombiniert wird, um einen entsprechenden der Vielzahl von Spannungs-Strom-Punkten zu erreichen.

3. Schaltvorrichtung (100) nach einem der vorhergehenden Ansprüche, die ferner Folgendes umfasst:
Verzögerungsschaltung (102) mit einem Eingang, der das Eingangssignal (DIN) empfängt, und mit einer Vielzahl von Ausgängen, die eine Vielzahl von verzögerten Signalen (D1-N) liefern, die jeweils durch eine inkrementelle Verzögerungszeit getrennt sind; und
wobei die Vielzahl von Slope-Steuerschaltungen (SC1-SCN) jeweils einen Eingang aufweist, der eines der Vielzahl von verzögerten Signalen (D1-N) empfängt, und jeweils einen Ausgang aufweist, der einen entsprechenden der Vielzahl von Treiberausgängen gemäß einer entsprechenden der Vielzahl von Slope-Funktionen bereitstellt.

4. Schaltvorrichtung (200) nach einem der Ansprüche 1 oder 2, wobei die Vielzahl von Slope-Steuerschaltungen (SC1-N) in einer Verkettung von einer ersten Slope-Steuerschaltung zu einer letzten Slope-Steuerschaltung gekoppelt sind, wobei die erste Slope-Steuerschaltung das Eingangssignal (DIN) empfängt, und wobei jede der ersten Slope-Steuerschaltung bis zu einer vorletzten Slope-Steuerschaltung einen Treiberausgang aufweist, der mit einem Eingang einer nächsten Slope-Steuerschaltung (SC1-N) gekoppelt ist.

5. Schaltvorrichtung (300) nach Anspruch 4, die ferner eine Verzögerungsschaltung (302) umfasst, die eine Vielzahl von Verzögerungsschaltungen (D1-DN) umfasst, die jeweils einen entsprechenden der Vielzahl von Treiberausgängen an den Ausgängen der Slope-Schaltung (204) verzögern.

6. Schaltvorrichtung (200) nach einem der Ansprüche 1 oder 2, die ferner Folgendes umfasst:
Verzögerungsschaltung (202) mit einem Eingang, der das Eingangssignal empfängt, und einem Ausgang, der ein verzögertes Signal liefert; und
wobei die Slope-Schaltung (204) eine Vielzahl von Slope-Steuerschaltungen (SC1-SCN) umfasst, die in einer Verkettung von einer ersten Slope-Steuerschaltung zu einer letzten Slope-Steuerschaltung gekoppelt sind, wobei die erste Slope-Steuerschaltung das verzögerte Signal empfängt, und wobei jede der ersten Slope-Steuerschaltung zu einer vorletzten Slope-Steuerschaltung einen Treiberausgang aufweist, der mit einem Eingang einer nächsten Slope-Steuerschaltung gekoppelt ist.

7. Schaltvorrichtung (100, 200, 300) nach einem der vorhergehenden Ansprüche, wobei jede der Vielzahl von Slope-Steuerschaltungen (SC1-SCN) Folgendes umfasst:
eine erste P-Kanal-Vorrichtung (P1) mit einem Source-Anschluss, der mit einem Versorgungsknoten (VDD) gekoppelt ist, mit einem Gate-Anschluss, der mit einem Eingangsknoten (820) gekoppelt ist, und mit einem Drain-Anschluss, der mit einem Zwischenknoten (822) gekoppelt ist;
eine erste N-Kanal-Vorrichtung (N1) mit einem Source-Anschluss, der mit einem Referenzversorgungsknoten (GND) gekoppelt ist, mit einem Gate-Anschluss, der mit dem Eingangsknoten (820) gekoppelt ist, und mit einem Drain-Anschluss, der mit dem Zwischenknoten (822) gekoppelt ist;
eine zweite P-Kanal-Vorrichtung (P3) mit einem Source-Anschluss, der mit dem Versorgungsknoten (VDD) gekoppelt ist, mit einem Gate-Anschluss, der mit dem oberen Knoten (810) gekoppelt ist, und mit einem Drain-Anschluss;
eine dritte P-Kanal-Vorrichtung (P2) mit einem Source-Anschluss, der mit dem Drain-Anschluss der zweiten P-Kanal-Vorrichtung (P3) gekoppelt ist, mit einem Gate-Anschluss, der mit dem Zwischenknoten (822) gekoppelt ist, und mit einem Drain-Anschluss, der mit dem Treiberausgangsknoten (824) gekoppelt ist;
eine zweite N-Kanal-Vorrichtung (N2) mit einem Drain-Anschluss, der mit dem Treiberausgangsknoten (824) gekoppelt ist, mit einem Gate-Anschluss, der mit dem Zwischenknoten (822) gekoppelt ist, und mit einem Source-Anschluss; und
eine dritte N-Kanal-Vorrichtung (N3) mit einem Drain-Anschluss, der mit dem Source-Anschluss der zweiten N-Kanal-Vorrichtung (N2) gekoppelt ist, mit einem Gate-Anschluss, der mit dem unteren Knoten (812) gekoppelt ist, und mit einem Source-Anschluss, der mit dem Referenzversorgungsknoten (GND) gekoppelt ist.

8. Schaltvorrichtung (100, 200, 300) nach einem der vorhergehenden Ansprüche, wobei jeder der Vielzahl von Stromzweigen einen Transistor umfasst, der einen ersten Stromanschluss hat, der mit dem Ausgangsknoten gekoppelt ist, der einen zweiten Stromanschluss hat, der mit dem Referenzknoten gekoppelt ist, und der einen Steueranschluss hat, der einen entsprechenden aus der Vielzahl von Treiberausgängen empfängt, und wobei der Transistor so bemessen ist, dass er einen entsprechenden Strom bereitstellt.

9. Schaltvorrichtung (100, 200, 300) nach einem der Ansprüche 1 bis 7, wobei jeder der Vielzahl von Stromzweigen Folgendes umfasst:
einen Widerstand mit einem ersten Ende, das mit dem Ausgangsknoten gekoppelt ist, und mit einem zweiten Ende; und
einen Transistor mit einem ersten Stromanschluss, der mit dem zweiten Ende des Widerstands gekoppelt ist, einem zweiten Stromanschluss, der mit dem Referenzknoten gekoppelt ist, und einem Steueranschluss, der einen entsprechenden aus der Vielzahl von Treiberausgängen empfängt;
wobei ein Widerstand des Widerstands und eine Größe des Transistors so gewählt werden, dass eine entsprechende Strommenge bereitgestellt wird.

10. Verfahren zum Schalten eines binären Signals unter Verwendung einer Schaltvorrichtung (100, 200, 300) nach Anspruch 1, das Folgendes umfasst:
Übergang eines Eingangssignals; und
Anwenden einer entsprechenden aus einer Vielzahl von Slope-Funktionen, jeweils eine, um einen entsprechenden aus einer Vielzahl von Treiberausgängen anzusteuern, um einen entsprechenden aus einer Vielzahl von Stromzweigen zu steuern, die zwischen einem Ausgangsknoten (108, 208, 308) und einem Referenzknoten vorgesehen sind, so dass der Ausgangsknoten (108, 208, 308) einer vorbestimmten Spannungs-Strom-Funktion folgt,
wobei jede Slope-Funktion eine lineare oder nichtlineare Funktion ist, die keine Stufenfunktion ist, um jeden Treiberausgang zwischen einem ersten und einem zweiten Spannungspegel mit einer konfigurierten oder inhärenten Verzögerung umzuschalten.

11. Verfahren nach Anspruch 10, wobei das Anwenden das Anwenden einer entsprechenden Slope-Funktion aus der Vielzahl der Slope-Funktionen umfasst, um einen entsprechenden Stromzweig aus der Vielzahl der Stromzweige zu aktivieren oder zu deaktivieren.

12. Verfahren nach Anspruch 10 oder Anspruch 11, wobei das Anwenden das selektive Schalten des stromarmen Inverters umfasst, der einen Lade- oder Entladestrom an den Kondensator (C1) liefert.

13. Verfahren nach einem der Ansprüche 10 bis 12, das ferner Folgendes umfasst:
Verzögern des Eingangssignals, um eine Vielzahl verzögerter Signale (D1-N) bereitzustellen, die jeweils durch eine inkrementelle Verzögerungszeit getrennt sind; und
Empfangen jedes der Vielzahl von verzögerten Signalen (D1-DN) durch eine entsprechende der Vielzahl von Slope-Steuerschaltungen (SC1-SCN), wobei jede einen entsprechenden der Vielzahl von Treiberausgängen gemäß einer entsprechenden der Vielzahl von Slope-Funktionen bereitstellt.

## Revendications

1. Appareil de commutation (100, 200, 300), comprenant :
une pluralité de branches de courant, chacune ayant des bornes de courant couplées entre un noeud de sortie (108, 208, 308) et un noeud de référence (GND), chacune ayant une borne de commande, et chacune développant un courant en réponse à un signal de pilotage (GD1-N) appliqué à la borne de commande ; et
une circuiterie de pente (104, 204, 304) ayant au moins une entrée répondant à un signal d'entrée (DIN) et ayant une pluralité de sorties de pilotage couplées chacune à une borne de commande d'une branche de courant correspondante parmi la pluralité de branches de courant, la circuiterie de pente (104, 204, 304) activant ou désactivant la pluralité de branches de courant une à la fois selon une fonction de pente correspondante parmi une pluralité de fonctions de pente en réponse à une transition du signal d'entrée (DIN) de telle sorte que le noeud de sortie (108, 208, 308) suive une fonction tension-courant prédéterminée,
chaque fonction de pente étant une fonction linéaire ou non linéaire autre qu'une fonction en escalier permettant d'assurer la transition de chaque sortie de pilotage entre des premier et second niveaux de tension avec un retard configuré ou inhérent, l'appareil de commutation étant **caractérisé en ce que** la circuiterie de pente (804) comprend en outre :
un miroir de courant (802) qui pilote un courant prédéterminé entre un noeud supérieur (810) et un noeud inférieur (812) ; et
une pluralité de circuits de commande de pente (SC1-SCN), chaque circuit de pente comprenant :
un condensateur (C1) couplé à un noeud de sortie de pilotage (824) fournissant un signal de pilotage correspondant parmi la pluralité de signaux de pilotage (GD1-GDN) ;
un premier onduleur ayant une entrée couplée à un noeud d'entrée (820) et ayant une sortie couplée à un noeud intermédiaire (822) ; et
un second onduleur couplé aux noeuds supérieur et inférieur (810, 812) du miroir de courant (802), ayant une entrée couplée au noeud intermédiaire (822) et une sortie couplée au noeud de sortie de pilotage (824) pour charger ou décharger le condensateur (C1) avec le courant prédéterminé.

2. Appareil de commutation (100, 200, 300) selon la revendication 1, dans lequel :
la fonction tension-courant prédéterminée comprend une pluralité de points tension-courant comprenant une pluralité de valeurs de tension, variant de manière incrémentale entre le premier niveau de tension et le second niveau de tension, et une pluralité correspondante de valeurs de courant ; et
dans lequel une résistance de chaque branche de courant parmi la pluralité de branches de courant est sélectionnée pour se combiner à une résistance totale afin d'atteindre un point tension-courant correspondant parmi la pluralité de points tension-courant.

3. Appareil de commutation (100) selon l'une quelconque des revendications précédentes, comprenant en outre :
une circuiterie de retard (102) ayant une entrée recevant le signal d'entrée (DIN) et ayant une pluralité de sorties fournissant une pluralité de signaux retardés (D1-N) séparés chacun par un temps de retard incrémental ; et
dans lequel la pluralité de circuits de commande de pente (SC1-SCN) ont chacun une entrée recevant un signal retardé parmi la pluralité de signaux retardés (D1-N) et ont chacun une sortie fournissant une sortie de pilotage correspondante parmi la pluralité de sorties de pilotage selon une fonction de pente correspondante parmi la pluralité de fonctions de pente.

4. Appareil de commutation (200) selon l'une quelconque des revendications 1 et 2, dans lequel la pluralité de circuits de commande de pente (SC1-N) sont couplés en guirlande d'un premier circuit de commande de pente à un dernier circuit de commande de pente, dans lequel le premier circuit de commande de pente reçoit le signal d'entrée (DIN), et dans lequel chaque circuit de commande de pente du premier circuit de commande de pente à un avant-dernier circuit de commande de pente a une sortie de pilotage couplée à une entrée d'un circuit de commande de pente (SC1-N) suivant.

5. Appareil de commutation (300) selon la revendication 4, comprenant en outre une circuiterie de retard (302) comprenant une pluralité de circuits de retard (D1-DN) retardant chacun une sortie de pilotage correspondante parmi la pluralité de sorties de pilotage au niveau des sorties de la circuiterie de pente (204).

6. Appareil de commutation (200) selon l'une quelconque des revendications 1 et 2, comprenant en outre :
une circuiterie de retard (202) ayant une entrée recevant le signal d'entrée et une sortie fournissant un signal retardé ; et
dans lequel la circuiterie de pente (204) comprend une pluralité de circuits de commande de pente (SC1-SCN) couplés en guirlande d'un premier circuit de commande de pente à un dernier circuit de commande de pente, dans lequel le premier circuit de commande de pente reçoit le signal retardé, et dans lequel chaque circuit de commande de pente du premier circuit de commande de pente à un avant-dernier circuit de commande de pente a une sortie de pilotage couplée à une entrée d'un circuit de commande de pente suivant.

7. Appareil de commutation (100, 200, 300) selon l'une quelconque des revendications précédentes, dans lequel chaque circuit de commande de pente parmi la pluralité de circuits de commande de pente (SC1-SCN) comprend :
un premier dispositif à canal P (P1) ayant une borne source couplée à un noeud d'alimentation (VDD), ayant une borne grille couplée à un noeud d'entrée (820), et ayant une borne drain couplée à un noeud intermédiaire (822) ;
un premier dispositif à canal N (N1) ayant une borne source couplée à un noeud d'alimentation de référence (GND), ayant une borne grille couplée au noeud d'entrée (820), et ayant une borne drain couplée au noeud intermédiaire (822) ;
un deuxième dispositif à canal P (P3) ayant une borne source couplée au noeud d'alimentation (VDD), ayant une borne grille couplée au noeud supérieur (810), et ayant une borne drain ;
un troisième dispositif à canal P (P2) ayant une borne source couplée à la borne drain du deuxième dispositif à canal P (P3), ayant une borne grille couplée au noeud intermédiaire (822), et ayant une borne drain couplée au noeud de sortie de pilotage (824) ;
un deuxième dispositif à canal N (N2) ayant une borne drain couplée au noeud de sortie de pilotage (824), ayant une borne grille couplée au noeud intermédiaire (822), et ayant une borne source ; et
un troisième dispositif à canal N (N3) ayant une borne drain couplée à la borne source du deuxième dispositif à canal N (N2), ayant une borne grille couplée au noeud inférieur (812), et ayant une borne source couplée au noeud d'alimentation de référence (GND).

8. Appareil de commutation (100, 200, 300) selon l'une quelconque des revendications précédentes, dans lequel chaque branche de courant parmi la pluralité de branches de courant comprend un transistor ayant une première borne de courant couplée au noeud de sortie, ayant une seconde borne de courant couplée au noeud de référence, et ayant une borne de commande recevant une sortie de pilotage correspondante parmi la pluralité de sorties de pilotage, et dans lequel le transistor est dimensionné pour fournir un courant correspondant.

9. Appareil de commutation (100, 200, 300) selon l'une quelconque des revendications 1 à 7, dans lequel chaque branche de courant parmi la pluralité de branches de courant comprend :
une résistance ayant une première extrémité couplée au noeud de sortie et ayant une seconde extrémité ; et
un transistor ayant une première borne de courant couplée à la seconde extrémité de la résistance, une seconde borne de courant couplée au noeud de référence, et une borne de commande recevant une sortie de pilotage correspondante parmi la pluralité de sorties de pilotage ;
une résistance de la résistance et une taille du transistor étant sélectionnées de manière à fournir une quantité de courant correspondante.

10. Procédé de commutation d'un signal binaire au moyen d'un appareil de commutation (100, 200, 300) selon la revendication 1, comprenant les étapes consistant à :
assurer la transition d'un signal d'entrée ; et
appliquer une fonction de pente correspondante parmi une pluralité de fonctions de pente, une à la fois, pour piloter une sortie de pilotage correspondante parmi une pluralité de sorties de pilotage afin de commander une branche de courant correspondante parmi une pluralité de branches de courant situées entre un noeud de sortie (108, 208, 308) et un noeud de référence de telle sorte que le noeud de sortie (108, 208, 308) suive une fonction tension-courant prédéterminée,
chaque fonction de pente étant une fonction linéaire ou non linéaire autre qu'une fonction en escalier permettant d'assurer la transition de chaque sortie de pilotage entre des premier et second niveaux de tension avec un retard configuré ou inhérent.

11. Procédé selon la revendication 10, dans lequel l'application comprend l'étape consistant à appliquer une fonction de pente correspondante parmi la pluralité de fonctions de pente afin d'activer ou de désactiver une branche de courant correspondante parmi la pluralité de branches de courant.

12. Procédé selon la revendication 10 ou 11, dans lequel l'application comprend l'étape consistant à commuter de manière sélective l'onduleur en manque de courant pilotant un courant de charge ou de décharge vers le condensateur (C1).

13. Procédé selon l'une quelconque des revendications 10 à 12, comprenant en outre les étapes consistant à :
retarder le signal d'entrée pour fournir une pluralité de signaux retardés (D1-N) séparés chacun par un temps de retard incrémental ; et
recevoir chaque signal retardé parmi la pluralité signaux retardés (D1-DN) par un circuit de commande de pente correspondant parmi la pluralité de circuits de commande de pente (SC1-SCN), chacun fournissant une sortie de pilotage correspondante parmi la pluralité de sorties de pilotage selon une fonction de pente correspondante parmi la pluralité de fonctions de pente.
